(19) Europäisches Patentamt
European Patent Office
Office européen des brevets

(11) **EP 4 492 024 A1**

(12) **EUROPEAN PATENT APPLICATION**
published in accordance with Art. 153(4) EPC

(43) Date of publication:
**15.01.2025 Bulletin 2025/03**

(21) Application number: **23857120.2**

(22) Date of filing: **28.07.2023**

(51) International Patent Classification (IPC):
***G01L 1/18*** (2006.01)

(52) Cooperative Patent Classification (CPC):
**G01L 1/18**

(86) International application number:
**PCT/JP2023/027815**

(87) International publication number:
**WO 2024/043005 (29.02.2024 Gazette 2024/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.08.2022 JP 2022132136**

(71) Applicants:
• **The University of Tokyo**
  **Bunkyo-ku, Tokyo 113-8654 (JP)**
• **Pi-Crystal Inc.**
  **Chiba 277-0005 (JP)**

(72) Inventors:
• **YAMASHITA, Yu**
  **Tokyo 113-8654 (JP)**
• **WATANABE, Shunichiro**
  **Tokyo 113-8654 (JP)**
• **TAKEYA, Junichi**
  **Tokyo 113-8654 (JP)**
• **NOZAWA, Han**
  **Kashiwa-shi, Chiba 277-0005 (JP)**
• **TSURUMI, Junto**
  **Kashiwa-shi, Chiba 277-0005 (JP)**

(74) Representative: **Grünecker Patent- und
Rechtsanwälte
PartG mbB
Leopoldstraße 4
80802 München (DE)**

(54) **ORGANIC SEMICONDUCTOR ELEMENT, STRAIN GAUGE, MEASUREMENT DEVICE, AND PRODUCTION METHOD FOR ORGANIC SEMICONDUCTOR ELEMENT**

(57)  Provided are an organic semiconductor element, a strain gauge, a measurement device, and a method for producing an organic semiconductor element, which contribute to highly accurate strain measurement. The element part 12 of a strain gauge includes an organic semiconductor film 21, a dopant layer 22, a protective layer 23, and a film 24 stacked on a substrate 11. At the interface of the organic semiconductor film 21 with the dopant layer 22, a doped layer 28 is formed of a dopant in the dopant layer 22. The film 24 is formed to cover the dopant layer 22 on the surface of the organic semiconductor film 21 and suppresses the incidence of light into the organic semiconductor film 21 and the dopant layer 22 and the permeation of water into the dopant layer 22.

Fig. 2

EP 4 492 024 A1

## Description

[Technical Field]

The present invention relates to an organic semiconductor element, a strain gauge, a measurement device, and a method for producing an organic semiconductor element.

[Background Art]

Strain gauges (strain sensors) provided with an organic semiconductor element are known (for example, see PTL 1 and 2). A strain gauge has an organic semiconductor film composed of a single crystal thin film of an organic semiconductor formed on a substrate and a pair of electrodes connected to this organic semiconductor film. When a stress to compress or stretch the organic semiconductor film is applied to the organic semiconductor film, the distance between molecules of the organic semiconductor changes, and the magnitude of vibration of molecules changes, which causes the carrier mobility of the organic semiconductor film to be changed. Strain is detected by detecting this change in the carrier mobility, for example, as a change in the resistance of the organic semiconductor film.

[Citation List]

[Patent Literature]

[PTL 1] WO 2016/121791 A1
[PTL 2] WO 2020/050288 A1

[Summary of Invention]

[Technical Problem]

Incidentally, strain gauges provided with an organic semiconductor element, as described above, have a much larger gauge factor (gauge coefficient) than strain gauges provided with a thin metal film. Therefore, such strain gauges are expected to be used in the measurement of more minute strains, i.e., highly accurate measurement of strains. Correspondingly, improvements in measurement noise, resistance temperature coefficient, stability, or the like are desired.
The present invention has been made in view of the above state and has an object to provide an organic semiconductor element, a strain gauge, a measurement device, and a method for producing an organic semiconductor element, which contribute to highly accurate strain measurement.

[Solution to Problem]

An organic semiconductor element of the present invention includes an organic semiconductor film that is formed as a single crystal of an organic semiconductor and has a doped layer on a surface thereof, a dopant layer that is formed on a surface of the organic semiconductor film and contains an ion pair-forming ion to form an ion pair with an ion of the organic semiconductor produced by generating carriers in the doped layer, and a film that is formed to cover the dopant layer on the surface of the organic semiconductor film and has one or both of a light-shielding property that suppresses the incidence of light into the organic semiconductor film and into the dopant layer, and a moisture-proof property that suppresses the permeation of water into the dopant layer.
The strain gauge of the present invention includes an organic semiconductor element, and a deformable substrate formed on one surface of the organic semiconductor element, the organic semiconductor element including an organic semiconductor film that is formed as a single crystal of an organic semiconductor and has a doped layer on a surface thereof, a dopant layer that is formed on a surface of the semiconductor film and contains an ion pair-forming ion to form an ion pair with an ion of the organic semiconductor produced by generating carriers in the doped layer, a film that is formed to cover the dopant layer on a surface of the organic semiconductor film and has one or both of a light-shielding property that suppresses the incidence of light into the organic semiconductor film and into the dopant layer, and a moisture-proof property that suppresses the permeation of water into the dopant layer, and a pair of electrodes electrically connected via the doped layer.
A measurement device of the present invention includes the strain gauge described above, an AC power source that applies an AC voltage to the organic semiconductor element of the strain gauge, and a detection circuit that outputs a detection signal according to the electrical resistance of the organic semiconductor element.

A method for producing an organic semiconductor element of the present invention includes an organic semiconductor film formation step of forming on a substrate an organic semiconductor film composed of a single crystal of an organic semiconductor and a dopant layer formation step of spreading a treatment liquid over a surface of the organic semiconductor film and thereafter evaporating a solvent in the treatment liquid to form a dopant layer that supplies carriers in the surface of the organic semiconductor film, the treatment liquid containing 2,2,2-trifluoroethanol as the solvent, and in the treatment liquid, an ionic liquid or salt that includes an alternative ion as either a cation or an anion is dissolved in the solvent, and an initiator dopant that oxidizes or reduces the organic semiconductor to form, after the oxidation or reduction, an ion with an identical polarity to the alternative ion is dissolved in the solvent, where an ion of the initiator dopant forms an intermediate with the organic semiconductor, and the alternative ion is replaced with the initiator dopant of the intermediate.

[Advantageous Effects of Invention]

According to the organic semiconductor element and strain gauge of the present invention, a film is formed so as to cover the dopant layer on a surface of the organic semiconductor film. Since this film suppresses the reaction that causes an increase or decrease in the charge density of the organic semiconductor, the stability of the organic semiconductor element is improved, and the changes in properties are suppressed, allowing highly accurate measurement of strains.

According to the measurement device of the present invention, the strain is measured while applying an AC voltage to the organic semiconductor element. Therefore, since no bias in the channel direction occurs in the distribution of ions and the like in the doped layer, no drift in properties of the organic semiconductor element occurs, allowing highly accurate measurement of strains.

According to the method for producing the organic semiconductor element of the present invention, by using 2,2,2-trifluoroethanol as a solvent for a treatment liquid when a dopant layer is formed, the amount doping into the organic semiconductor film increases, the stability of the doped state against heat improves, the stability over time improves, and the active energy of electrical conduction in the doped layer decreases, allowing highly accurate measurement of strains using the organic semiconductor element.

[Brief Description of Drawings]

[Fig. 1]

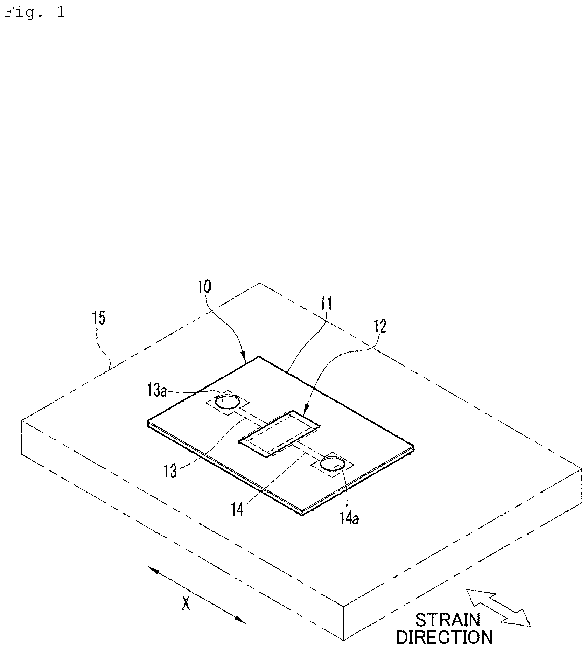

Fig. 1 is a perspective view illustrating a strain gauge.
[Fig. 2]

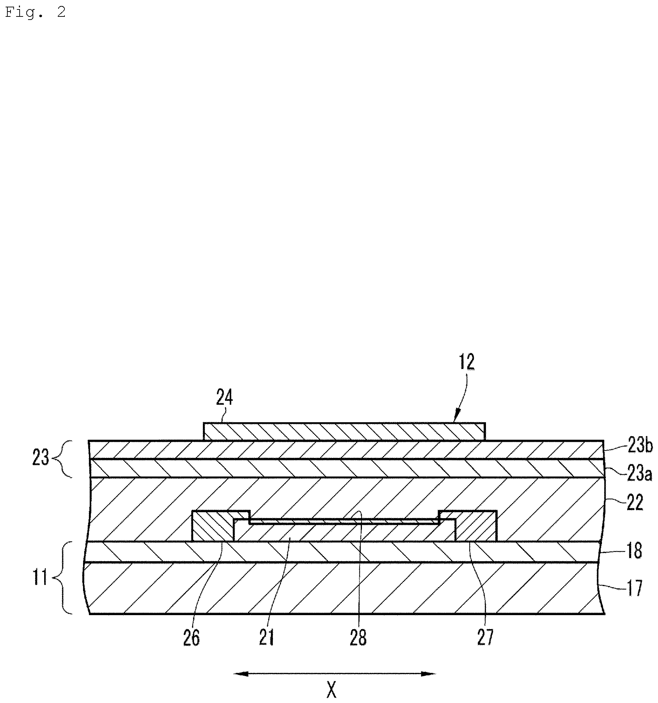

Fig. 2 is a cross-sectional view illustrating the structure of the strain gauge.
[Fig. 3]

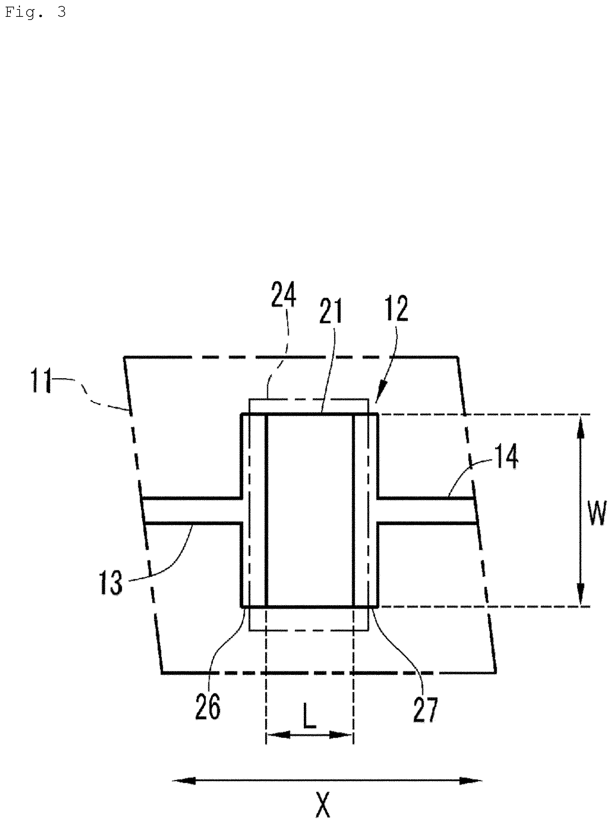

Fig. 3 is a plan view illustrating a semiconductor part.
[Fig. 4]

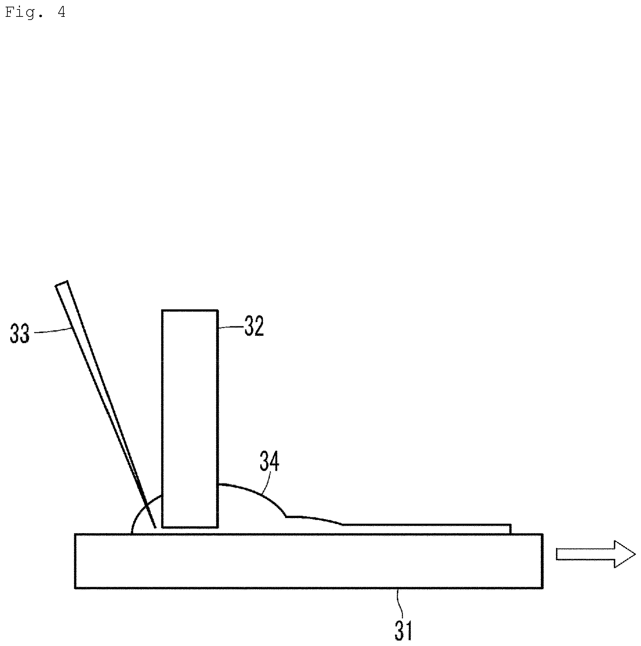

Fig. 4 is an explanatory diagram illustrating the formed state of an organic semiconductor film by an edge-casting method.
[Fig. 5]

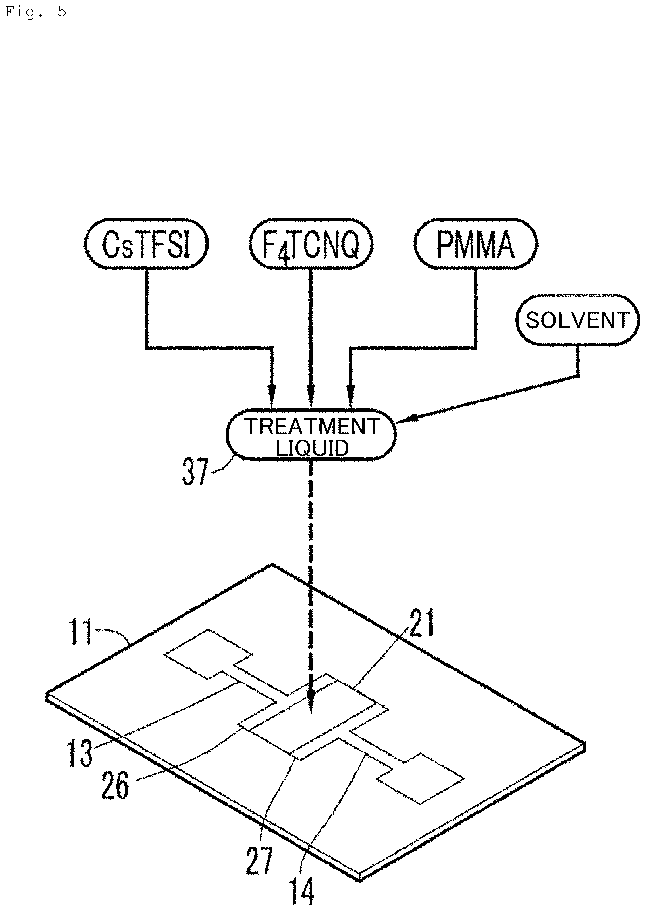

Fig. 5 is an explanatory diagram illustrating the process of preparing a dope film.
[Fig. 6]

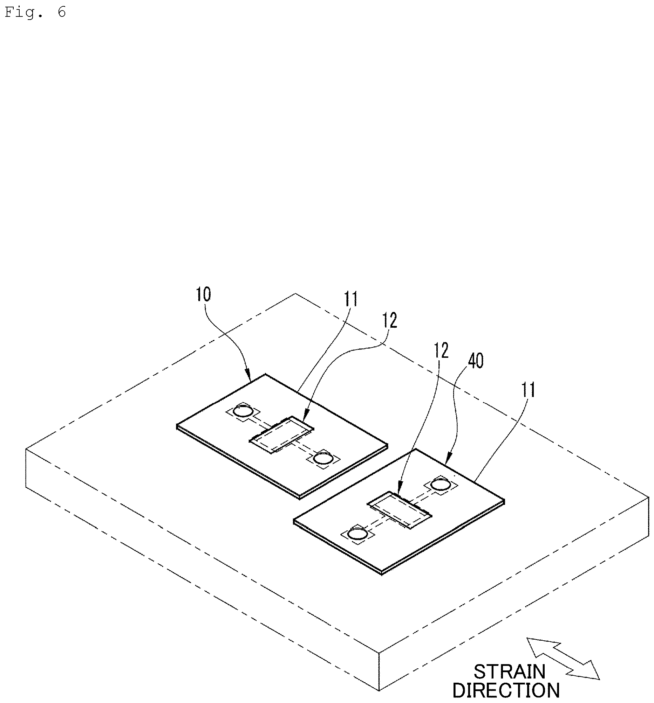

Fig. 6 is an explanatory diagram illustrating the state where a strain gauge and a dummy strain gauge are attached to a measurement target.
[Fig. 7]

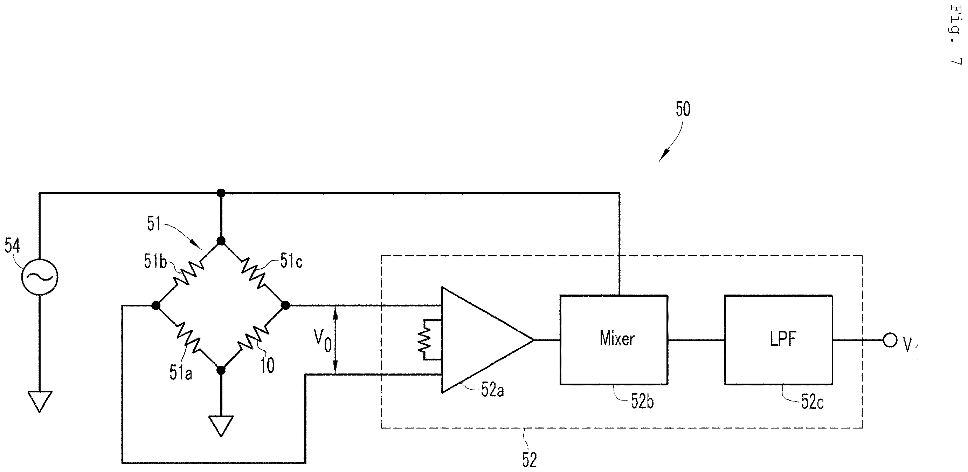

Fig. 7 is a block diagram illustrating an example of a measurement device using a strain gauge.
[Fig. 8]

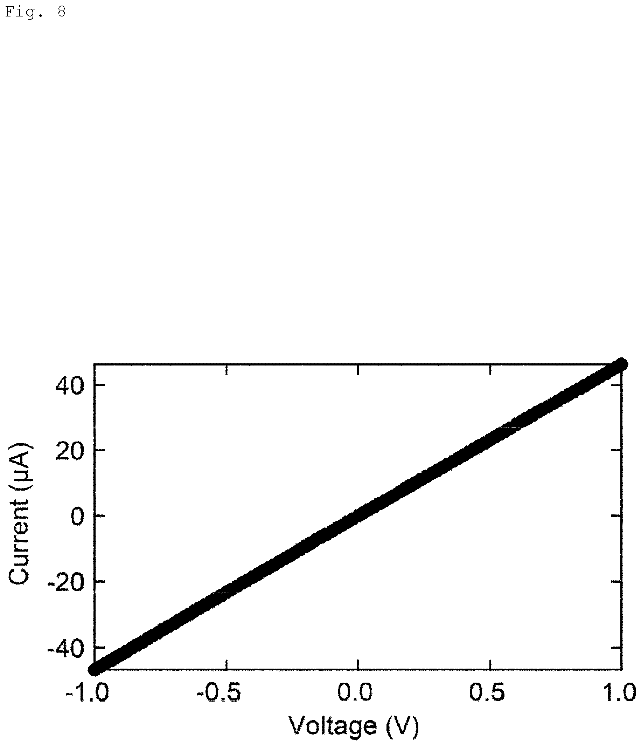

Fig. 8 is a graph illustrating the I-V properties of a strain gauge sample fabricated using 2,2,2-trifluoroethanol as a solvent for a treatment liquid.
[Fig. 9]

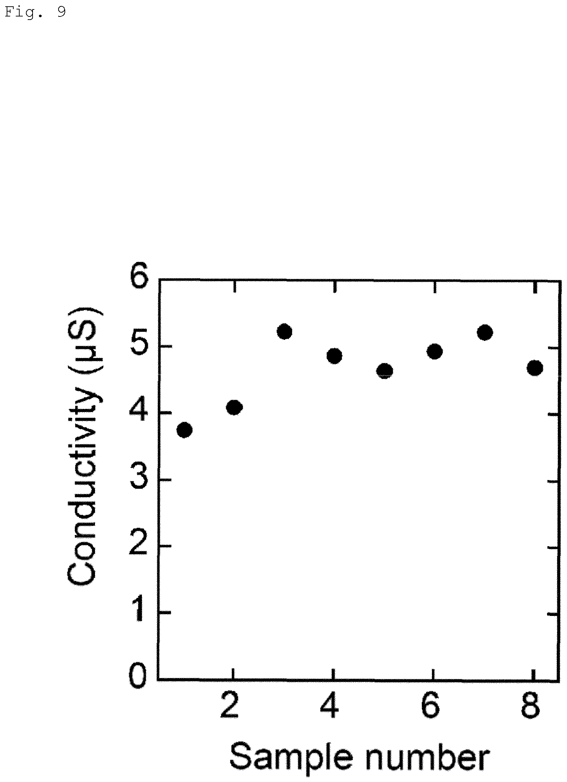

Fig. 9 is a graph illustrating the conductivity of each sample of a strain gauge fabricated using 2,2,2-trifluoroethanol as a solvent for a treatment liquid.
[Fig. 10]

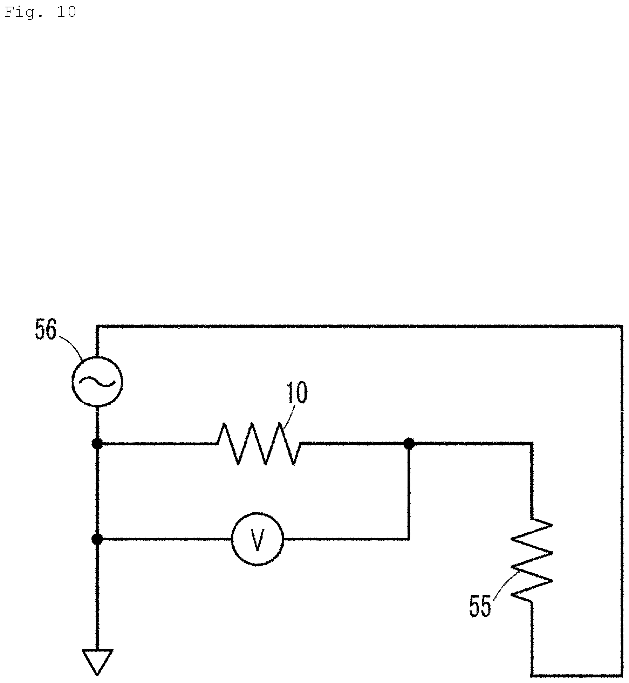

Fig. 10 is a circuit diagram illustrating a voltage-dividing circuit used in the Examples.

[Fig. 11]

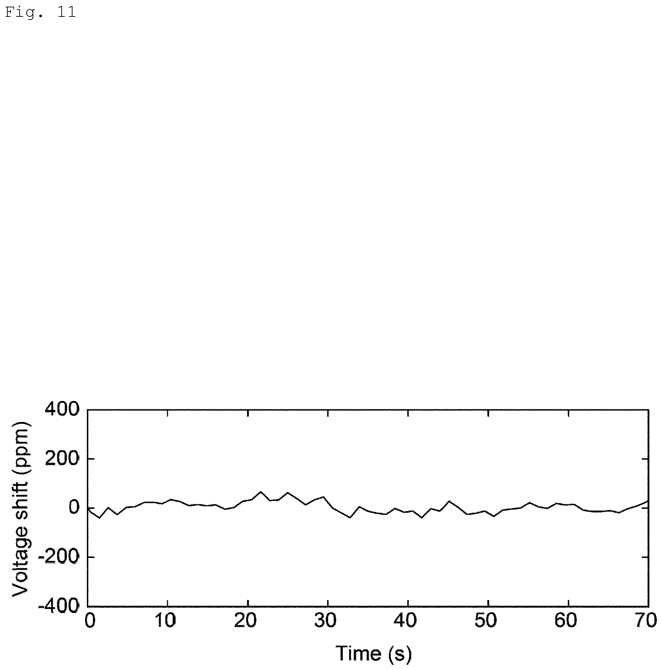

Fig. 11 is a graph indicating the measurement result of the rate of voltage fluctuation measured while applying an AC voltage to a strain gauge sample.

[Fig. 12]

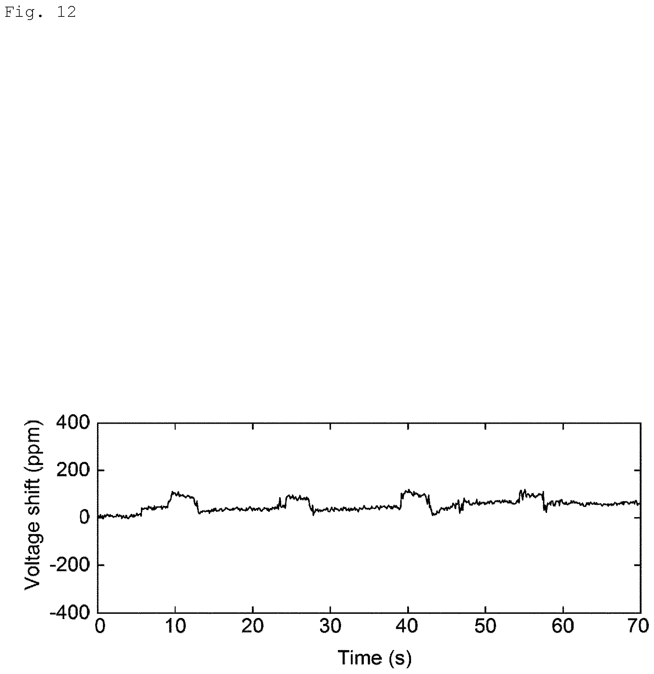

Fig. 12 is a graph indicating the measurement result of the rate of voltage fluctuation measured while applying a DC voltage to a strain gauge sample.

[Fig. 13]

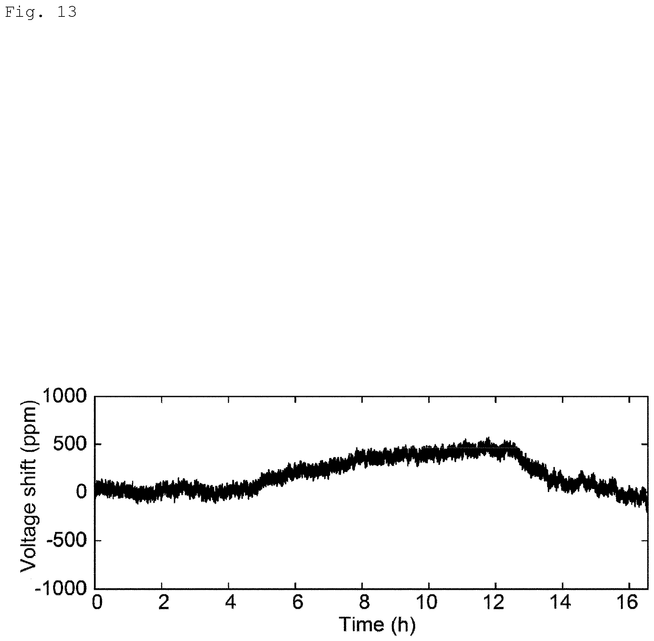

Fig. 13 is a graph indicating a partial period of a measurement result of the rate of voltage fluctuation while applying an AC voltage to a sample of a strain gauge over a long period of time.

[Fig. 14]

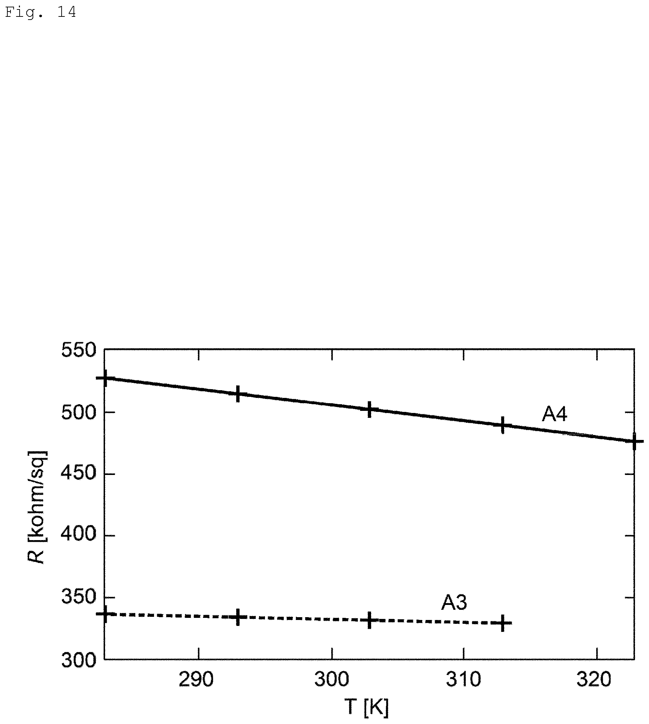

Fig. 14 is a graph indicating the relationship between the temperature and the surface resistivity of the doped layer when the resistance temperature coefficient of a sample of a strain gauge is measured.

[Fig. 15]

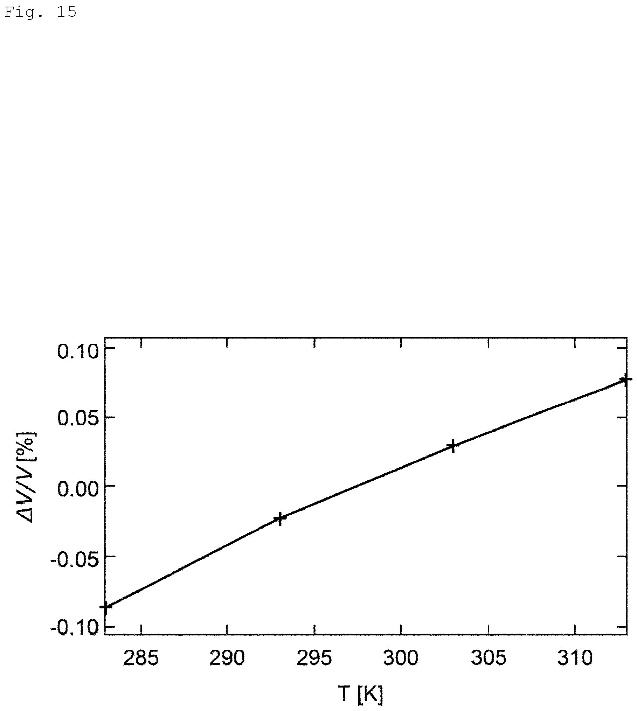

Fig. 15 is a graph indicating the results of the measurement of the changes in voltage drop of a sample of a strain gauge against the temperature change when a dummy strain gauge is used in combination.

[Fig. 16]

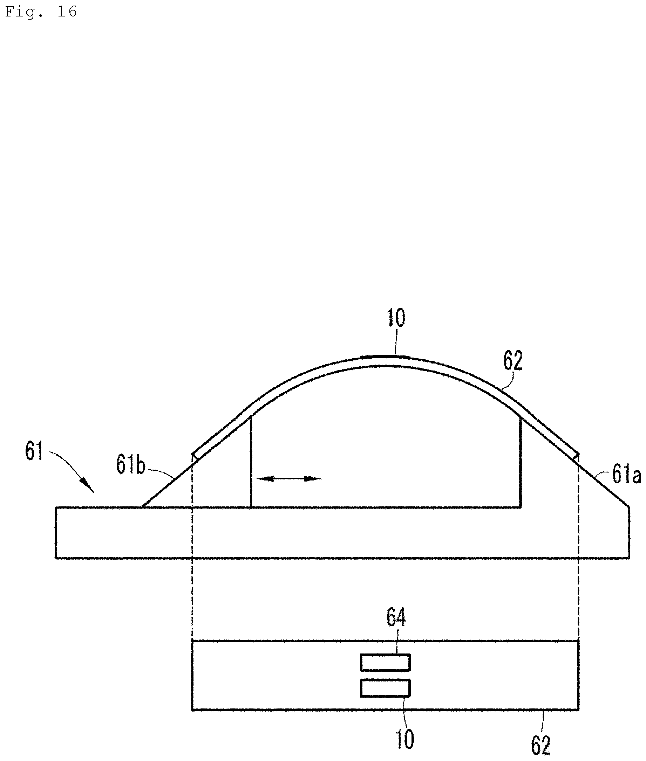

Fig. 16 is an explanatory diagram illustrating a state where a stainless-steel plate on which a sample of a strain gauge is affixed is attached to a one-axis automatic stage.

[Fig. 17]

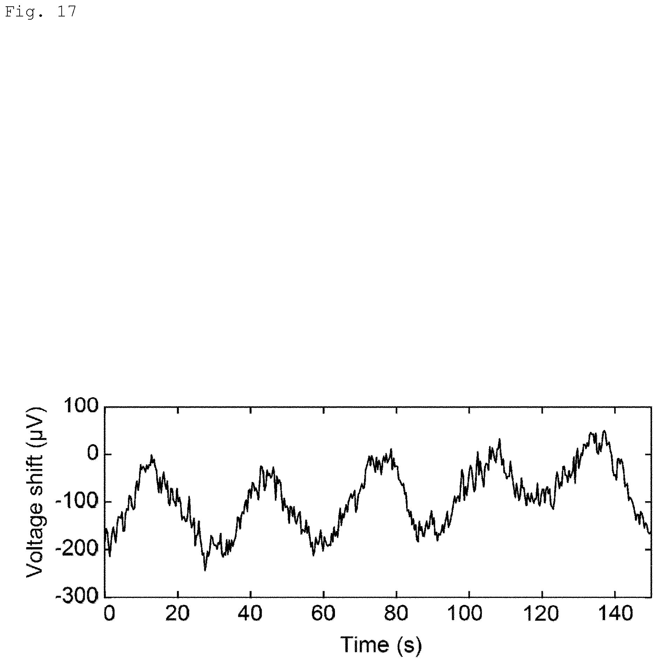

Fig. 17 is a graph illustrating the change in the voltage drop of a sample of a strain gauge affixed on a stainless-steel plate when the degree of bending of a stainless-steel plate is changed periodically and repeatedly.

[Fig. 18]

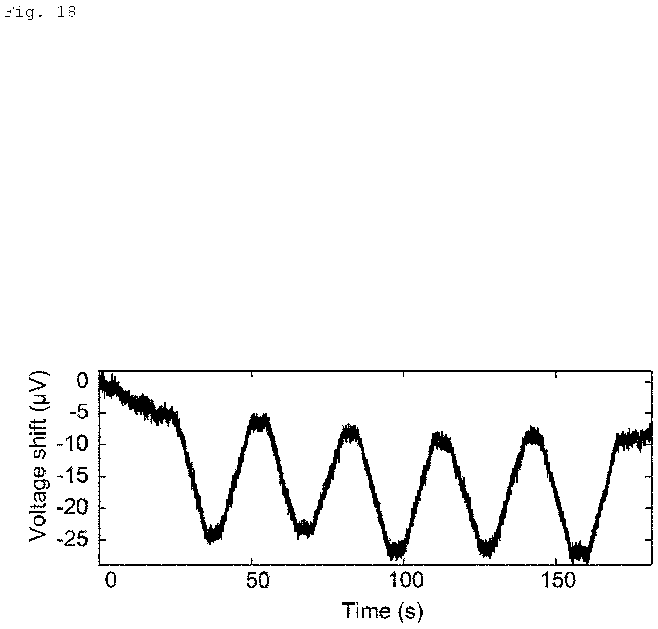

Fig. 18 is a graph illustrating the change in the voltage drop of a commercially available strain gauge affixed on a stainless-steel plate when the degree of bending of a stainless-steel plate is changed periodically and repeatedly.

[Fig. 19]

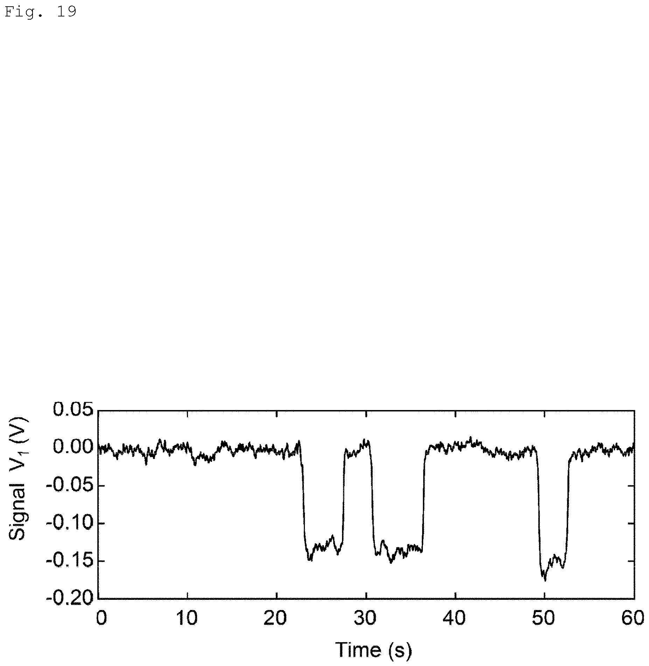

Fig. 19 is a graph illustrating the detection signals detected using a lock-in amplifier when the degree of bending of a stainless-steel plate is changed intermittently.

[Fig. 20]

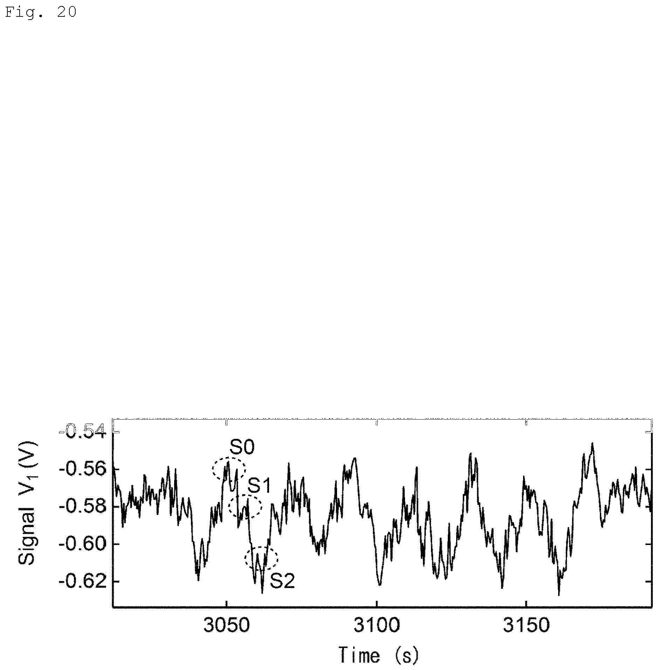

Fig. 20 is a graph illustrating the detection signals detected using a lock-in amplifier when a stainless-steel plate is bent slightly.

[Fig. 21]

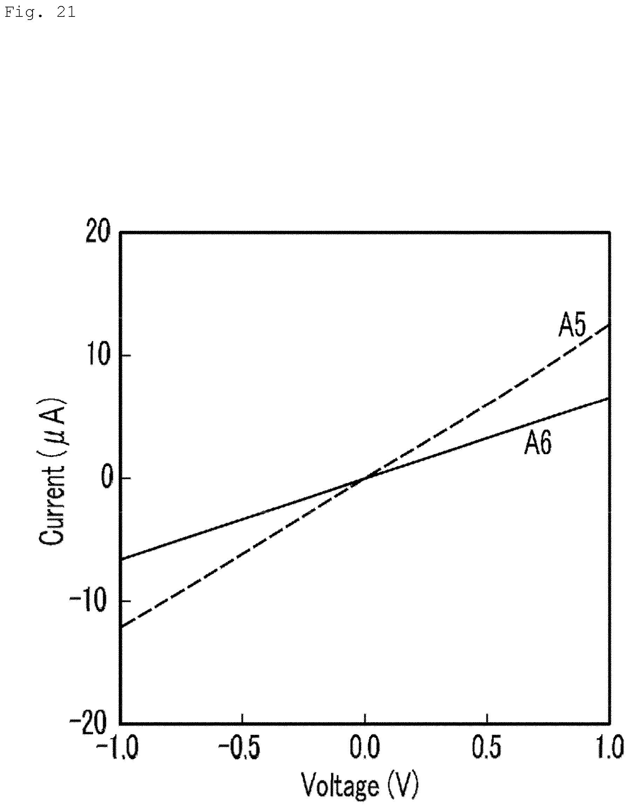

Fig. 21 is a graph indicating the measurement result of the I-V properties on two samples of strain gauges in which PVDF-HFP is used in a retaining material.

[Description of Embodiments]

In Fig. 1, a strain gauge (strain sensor) 10 includes a substrate 11, and an element part 12 and wires 13 and 14 formed as organic semiconductor elements on a surface of this substrate 11. This strain gauge 10 uses a phenomenon that the electrical resistance of an organic semiconductor film, which will be described later, constituting the element part 12 changes according to the strain of the organic semiconductor film. For example, the strain gauge 10 is affixed in a state where the back surface (opposite side surface to the element part 12) of the substrate 11 is in close contact with the front surface of a measurement target 15 to measure the strain that occurs in the measurement target 15. The strain gauge 10 is affixed to the measurement target 15 so that the measurement axis direction (X direction) set thereto should coincide with the direction of the strain to be measured of the measurement target 15 (the direction of stretching or compression). The strain gauge 10 is connected to an external detection circuit via terminals 13a and 14a, disposed on each end of the wires 13 and 14 to detect the electrical resistance of the element part 12.

The strain gauge 10 may be, for example, an acceleration sensor, a vibration sensor, or one of various sensors that detect the inclination or movement of a detection target. Furthermore, an organic semiconductor element may be used for other purposes other than strain gauges.

In Fig. 2, the substrate 11 of this example has a two-layer structure consisting of a base layer 17 and an insulating layer 18 formed on a surface of this base layer 17, and the element part 12 is formed on a surface of the insulating layer 18. This substrate 11 is formed to be deformable so as to integrally deform with a surface of the measurement target 15. For example, the base layer 17 is formed of a polyimide resin and imparts moderate rigidity to the substrate 11 to facilitate the handling of the strain gauge 10. For example, the insulating layer 18 is formed of poly(p-xylene) (Parylene (registered trademark)) and imparts good insulation and smoothness to the surface of the substrate 11. The material and structure of the substrate 11 are not limited to these.

The element part 12 includes an organic semiconductor film 21 formed on a surface of the insulating layer 18, a dopant layer 22, a protective layer 23, and a film 24, which are stacked on this organic semiconductor film 21, and electrodes 26 and 27. The electrodes 26 and 27 are formed separately from each other in the measurement axis direction, and the organic semiconductor film 21 is formed between the electrodes 26 and 27. For example, the electrodes 26 and 27 are each formed of Au (gold). In this example, the dopant layer 22 and the protective layer 23 are formed in areas other than the element part 12 of the substrate 11, but these may be formed only on the organic semiconductor film 21.

The organic semiconductor film 21 is made of a single crystal of a P-type or N-type organic semiconductor (an organic compound (organic molecules) exhibiting semiconductor properties) and is formed by shaping this single crystal into a film shape. When the organic semiconductor film 21 is formed by an edge-casting method, which will be described later, an organic semiconductor that is dissolved in an organic solvent is used. For example, the thickness of the organic semiconductor film 21 is 10 nm or less. On the surface of this organic semiconductor film 21, a doped layer 28 in which carriers (holes or electrons) are generated (injected) is formed.

As an organic semiconductor to form the organic semiconductor film 21, those forming a single crystal are used. As described later, when the organic semiconductor is P-type, those with a HOMO level that satisfies a specific condition with respect to the LUMO level of the initiator dopant are used, and when the organic semiconductor is N-type, those with a LUMO level that satisfies a specific condition with respect to the HOMO level of the initiator dopant are used.

Examples of P-type organic semiconductors constituting the organic semiconductor film 21 may include 3,11-dioctyldinaphtho[2,3-d:2',3'-d']benzo[1,2-b:4,5-b']dithiophene (C8-DNBDT), 3,11-didecyldinaphtho[2,3-d:2',3'-d']benzo[1,2-b:4,5-b']dithiophene (C10-DNBDT), 3,9-dihexyldinaphtho[2,3-b;2',3-d]thiophene (C6-DNT), 2,9-dinaphtho[2,3-b:2',3'-f]thieno[3,2-b]thiophene (C10-DNTT), 2,7-dioctylbenzothieno[3,2-b][1]benzothiophene (C8-BTBT), 6,13-bis(triisopropylsilylethynyl)pentacene, and the like. Examples of N-type organic semiconductor materials constituting the organic semiconductor film 21 may include dicyanoperylene-3,4:9,10-bis(dicarboximide) and the like.

The dopant layer 22 is formed on a surface of the organic semiconductor film 21 as a film containing an ion pair-forming ion to the organic semiconductor film 21. In this example, the dopant layer 22 contains alternative ions as ion pair-forming ions, as well as an initiator dopant and spectator ions. The dopant layer 22 may have a configuration in which an initiator dopant and spectator ions are removed from the dopant layer 22. Furthermore, the dopant layer 22 contains a retaining material that retains the dopant layer 22 in the form of a film.

The alternative ions in the dopant layer 22 form ion pairs with ions of an organic semiconductor of the organic semiconductor film 21 at the interface between the organic semiconductor film 21 and the dopant layer 22. As the details are described below, organic semiconductor ions that form ion pairs with alternative ions in this example are generated by oxidation or reduction of an organic semiconductor by an initiator dopant in order to generate carriers of the doped layer 28.

The doped layer 28 is formed in a state where carriers are injected by the initiator dopant and the alternative ions, as described above. The initiator dopant forms ions with the same polarity as the alternative ions after oxidizing or reducing the organic semiconductor of the organic semiconductor film 21 in the formation process of the doped layer 28. This initiator dopant produces carriers by oxidation or reduction of an organic semiconductor. In this formation process, ions of an organic semiconductor oxidized or reduced by the initiator dopant form an intermediate with ions of the initiator dopant that oxidized or reduced the ions of the organic semiconductor.

The alternative ions are replaced with the initiator dopant of the intermediate by ion exchange and form ion pairs with ions of the organic semiconductor of the organic semiconductor film 21. As such, alternative ions make the surface of the organic semiconductor film 21 doped. Doping using this method allows for larger doping amounts. Spectator ions form salts with alternative ions in the formation process of the doped layer 28, and the exchange between alternative ions and ions of the initiator dopant occurs between this salt and the intermediate. The final state should be that ion pairs are formed between the ions of the organic semiconductor in the organic semiconductor film 21 and the alternative ions. Accordingly, the dopant layer 22 should be the dopant layer 22 from which initiator dopants and spectator ions are removed.

In the dopant layer 22, some of the alternative ions form ion pairs with the organic semiconductor and the rest thereof forms salts with spectator ions. Alternative ions are the first ions, and the ions of the initiator dopant are the second ions. Details of the formation process, etc., of the alternative ions, the initiator dopant, the spectator ions, and the doped layer 28 will be described later.

As a retaining material of the dopant layer 22, polymer materials such as PMMA (poly(methyl methacrylate) resin), PVDF-HFP (poly(vinylidene fluoride-co-hexafluoropropylene)), PADMA (poly(adamantyl methacrylate) resin), and polyethylene oxide may be used. A preferable retaining material has low hygroscopicity, and from this viewpoint, PVDF-HFP is a preferred polymer material. The use of a retaining material with low hygroscopicity allows for the suppression of the reduction of charge density of the initiator dopant and the organic semiconductor due to water in the air after the production process and the formation of the dopant layer 22. This allows for higher conductivity of the organic semiconductor film 21, maintenance of high conductivity, and better stability. From the viewpoint of reducing hygroscopicity, it is also preferable that the dopant layer 22 does not contain a retaining material.

A protective layer 23 protects the organic semiconductor film 21 and the dopant layer 22 including a doped layer 28. In this example, the protective layer 23 is formed on almost the entire surface of the substrate 11 on the organic semiconductor film 21 side and protects the organic semiconductor film 21 and the dopant layer 22, as well as the wires 13 and 14 and electrodes 26 and 27.

In this example, the protective layer 23 is constituted of a first protective layer 23a and a second protective layer 23b. The first protective layer 23a is formed of "CYTOP (registered trademark)" on the dopant layer 22, and the second protective layer 23b is formed of poly(p-xylene) on this first protective layer 23a. A material that can be stacked on the organic semiconductor film 21 and the dopant layer 22 without damage is selected for the first protective layer 23a, and desirable examples thereof include fluororesin materials, including CYTOP. The second protective layer 23b serves to protect the organic semiconductor film 21 and the dopant layer 22 from damage by the stacking process of the film 24.

The film 24 is formed on the protective layer 23 so as to cover the organic semiconductor film 21 and the dopant layer 22 directly above the organic semiconductor film 21. That is, the film 24 is formed across the protective layer 23 to cover the part of the organic semiconductor film 21 and the dopant layer 22 on the upper layer thereof, which constitute the element part 12. Actually, the film 24 covers a wider area than the organic semiconductor film 21 and also covers a part of the electrodes 26 and 27.

The film 24 suppresses the incidence of light on the organic semiconductor film 21 and the dopant layer 22 directly above the organic semiconductor film 21 and moisture absorption into the dopant layer 22 directly above the organic semiconductor film 21. In this example, the film 24 is in the form of a film of Al (aluminum) with a thickness of, for example, 50 nm. The material of the film 24 is not limited as long as the material has a light-shielding property of blocking light and a moisture-proof property of suppressing water permeation. The film 24 is preferably formed of a material that has a small effect impact on the stretching or compression of the organic semiconductor film 21 due to the deformation of the measurement target or has a film thickness adjusted so that the effect is small. That is, it is preferred that the film 24 deforms together with the substrate 11 or the like by small force. Examples of preferred materials for the film 24 include metals, and metals that do not deteriorate due to oxidation or the like are particularly preferred.

The film 24 suppresses the reduction of charge density of the organic semiconductor in the organic semiconductor film 21 due to the charge transfer reaction between the organic semiconductor and water or other reactions. Furthermore, the film 24 suppresses the incidence of light into the organic semiconductor film 21 and the dopant layer 22, the formation of photo-carriers, and the change of the resistance of the doped layer 28. This suppresses the deterioration over time of the strain gauge 10 and the reduction of the measurement accuracy. Furthermore, in this example, the effect of electrical noise on the strain gauge 10 by forming the film 24 with a conductive material (Al).

The film 24 may have either one of a light-shielding property of blocking light and a moisture-proof property of suppressing water permeation, but preferably has both. Alternatively, the film 24 may be multi-layered with two or more layers to block light and suppress water permeation. Furthermore, the film 24 may be formed on a wider range, for example, on the entire surface of the protective layer 23, excluding the parts of terminals 13a and 14a. Furthermore, in this example, the film 24 suppresses an increase or decrease of the charge density of the organic semiconductor in the organic semiconductor film 21 doped by ion exchange, as described above. Alternatively, the deactivation of ion pairs including ions of an organic semiconductor formed by a doping method other than ion exchange and the reduction of the charge density of an organic semiconductor due to the deactivation can be suppressed. For example, the film 24 is useful even if it is an organic semiconductor element in which the ion of the initiator dopant finally serves as an ion pair-forming ion to form an ion pair with an ion of an organic semiconductor by doping without using an alternative ion. Accordingly, the film 24 is useful even in a configuration in which, for example, ion pair-forming ions adhere as the dopant layer 22 to the surface of the organic semiconductor film 21.

In Fig. 3, the organic semiconductor film 21 is formed in a rectangular shape on the surface of the substrate 11, and a pair of opposing sides are arranged in parallel in the measurement axis direction (X direction). The organic semiconductor film 21 is stretched or compressed together with the surface of the substrate 11 by the deformation of the measurement target, thereby changing the electrical resistance of the doped layer 28. The electrodes 26 and 27 with the same length as the sides in the direction (Y direction) perpendicular to the measurement axis direction of the organic semiconductor film 21 are provided along the side on the substrate 11. The length of the semiconductor film 21 in the X direction (an interval between the electrodes 26 and 27) is the channel length L, and the length in the Y direction is the channel width W of the element part 12. A large channel width W is preferable from the viewpoint of reducing noise. In this example, the channel width is 4 mm, and the channel length L is 0.4 mm.

Next, the fabrication of the strain gauge 10 is explained. The fabrication procedure described below is illustrative and is not limited thereto. When the strain gauge 10 is fabricated, the formation of the organic semiconductor film 21, the formation of the electrodes 26 and 27, the formation of the dopant layer 22, the formation of the protective layer 23, and the formation of the film 24 are sequentially performed.

For example, the organic semiconductor film 21 is formed by an edge-casting method. As illustrated in Fig. 4, in an edge-casting method, a solution 34 is supplied between a substrate 31 and a blade 32, which is arranged substantially perpendicular to the substrate 31, from a supply tube 33 while relatively moving the substrate 31 and the blade 32 in one direction (in the example of Fig. 4, the substrate 31 is moved to the right). The solution 34 contains an organic semiconductor, which forms the organic semiconductor film 21, in a solvent. This deposits an organic semiconductor on the substrate 31 while spreading the solution 34 over the substrate 31 in one direction and evaporating the solvent in the solution 34, thereby forming a thin film of a single crystal of the organic semiconductor. As a substrate 31, a glass plate with a hydrophilic treated surface or the like is used. The thin film of a single crystal of the organic semiconductor is transferred to the substrate 11 as the organic semiconductor film 21 in a state of being patterned in the shape of the organic semiconductor film 21. Alternatively, the thin film may be patterned in the shape of the organic semiconductor film 21 after the transfer to the substrate 11. Alternatively, the organic semiconductor film 21 may be formed directly on the substrate 11 by spreading the solution 34 over the substrate 11.

As a solvent for the solution 34, for example, an aromatic compound (o-dichlorobenzene or the like) may be used. Alternatively, as the solution 34, a solution containing a polymer material and an organic semiconductor, which forms the organic semiconductor film 21, in a solvent may be used. Examples of polymer materials in this case may include PMMA, poly(4-methylstyrene), poly(triarylamine), polystyrene, polyacrylonitrile, polyethylene, polyvinyl acetate, and the like. A solvent in this case is not particularly limited as long as the solvent dissolves both an organic compound and a polymer, but, for example, halogenated aromatic solvents such as chlorobenzene, 3-chlorothiophene, and 1-chloronaphthalene, hydrocarbon solvents such as hexane and heptane, non-halogenated aromatic solvents such as toluene, xylene, and tetralin, and the like may be used.

For example, the details of the edge-casting method are described in WO 2021/182545 or the like.

The organic semiconductor film 21 is formed on the substrate 11 as described above. In this case, the organic semiconductor film 21 is formed on the substrate 11 so that the spreading direction of the solution 34 during the formation (relative movement direction of the substrate 31 and the blade 32) should be coincident with the measurement axis direction, for example. In the organic semiconductor film 21 fabricated as above, π-conjugated planar portions of each organic semiconductor in the film have a standing orientation relative to the substrate, i.e., edge-on orientation. The edge-on oriented organic semiconductor film 21 facilitates the flow of electricity in the in-plane direction of the substrate and allows the detection of the change in the electrical resistance of the organic semiconductor film 21 due to stretching or compression with good sensitivity. That is, the organic semiconductor film 21 is formed on the substrate 11 by aligning organic semiconductor molecules so that good electric conductivity should be shown in the measurement axis direction.

After forming the organic semiconductor film 21 on the substrate 11, the electrodes 26 and 27 are formed. The electrodes 26 and 27 are formed on the substrate 11 by, for example, vapor deposition, together with the wires 13 and 14. The method for forming the wires 13 and 14 and the electrodes 26 and 27 may be various methods as long as the methods do not degrade or destroy the organic semiconductor film 21.

After forming the electrodes 26 and 27, doping by ion exchange is performed simultaneously to the formation of the dopant layer 22. The dopant layer 22 is formed by spreading a treatment liquid 37 (see Fig. 5), in which dopant materials that produce an initiator dopant, spectator ions, and alternative ions, and a retaining material are dissolved, over the surface of the organic semiconductor film 21 and evaporating a solvent.

A solution containing an initiator dopant with the same polarity (anions or cations) as the alternative ions and a retaining material dissolved in an ionic liquid, which is a liquid of a salt constituted by spectator ions and alternative ions, is used as the treatment liquid 37. The salt constituted of the spectator ions and the alternative ions does not need to be liquid by itself, but may be dissolved in an organic solvent when used.

For example, when A is the organic semiconductor of the organic semiconductor film 21, B is an initiator dopant, C is a chemical species that produces spectator ions, and D is a chemical species that produces alternative ions, the doping by the ion exchange described above may be expressed as the following formula (1) when the organic semiconductor is a P-type or as the following formula (2) when the organic semiconductor is an N-type.

[Math. 1]

$$A + B + [C]^+ + [D]^- \rightleftarrows [A]^+[B]^- + [C]^+ + [D]^- \rightleftarrows [A]^+[D]^- + [C]^+ + [B]^-$$
$$\cdots (1)$$

$$A + B + [C]^- + [D]^+ \rightleftarrows [A]^-[B]^+ + [C]^- + [D]^+ \rightleftarrows [A]^-[D]^+ + [C]^- + [B]^+$$
$$\cdots (2)$$

For example, when the organic semiconductor is a P-type, a redox reaction between the organic semiconductor (A) and the initiator dopant (B) occurs on the surface of the organic semiconductor film 21 in contact with the treatment liquid 37, and an intermediate ($[A]^+[B]^-$) composed of the cation ($[A]^+$) of the organic semiconductor (A) and the anion ($[B]^-$) of the initiator dopant (B) is formed. At this time, a charge transfer occurs between the HOMO (Highest Occupied Molecular Orbital) of the organic semiconductor and the LUMO (Lowest Unoccupied Molecular Orbital) of the initiator dopant, and carriers (holes in this example) are injected into the surface (the outer layer) of the organic semiconductor film 21. The redox reaction between the organic semiconductor and the initiator dopant is reversible, and once an equilibrium state is established, the amount of the intermediate produced does not increase.

When anions ([D]⁻) of the alternative dopant that are more likely to chemically form pairs with the cations ([A]⁺) of the organic semiconductor than with the anions ([B]⁻) of the initiator dopant are present in the dopant layer 22, the anions ([B]⁻) of the initiator dopant forming an intermediate are replaced (ion-exchanged) with the alternative ions ([D]⁻), forming ion pairs ([A]⁺[D]⁻). When this ion exchange occurs, a redox reaction occurs between the organic semiconductor and the initiator dopant so that an equilibrium state should be maintained, and anions of the initiator dopant of the intermediate formed by the redox reaction are replaced with the alternative ions. As a result, the organic semiconductor film 21 is doped with the alternative ions.

By the above ion exchange, components of the right-hand side of the equilibrium related to the redox reaction, i.e., the number of the intermediate ([A]⁺[B]⁻) remarkably decreases, and a biased equilibrium occurs, thus accelerating a redox reaction. Therefore, a higher doping amount into the organic semiconductor film 21 can be achieved by such a doping method than only by a redox reaction.

The same applies to the case where an N-type organic semiconductor is used. In the case of the N-type organic semiconductor film 21, charge transfer occurs between the LUMO of the organic semiconductor and the HOMO of the initiator dopant, i.e., carriers (electrons) are transferred and injected onto the surface of the organic semiconductor film 21, and cations ([B]⁺) of the initiator dopant forming an intermediate are replaced with alternative ions ([D]⁺), thereby forming ion pairs ([A]⁻[D]⁺). This accelerates the redox reaction between the organic semiconductor and the initiator dopant.

As the initiator dopant when a P-type organic semiconductor is used, a molecule or metal complex that can oxidize other molecules by receiving electrons in the LUMO level thereof is used. Examples of such an initiator dopant may include 2,3,5,6-tetrafluoro-7,7,8,8-tetracyanoquinodimethane ($F_4$TCNQ, CAS No. 29261-33-4), 7,7,8,8-tetracyanoqui-nodimethane, Mo(tfd-COCF$_3$)$_3$, and the like. When $VH_1$ (eV) is an ionization potential originating from the HOMO level of a P-type organic semiconductor, and $VL_1$ (eV) is an electron affinity originating from the LUMO level of an initiator dopant, it is preferable to satisfy the condition: "$VH_1 \leq VL_1 + 1.0$ (eV)".

As alternative ions when a P-type organic semiconductor is used, anions with a closed shell structure capable of forming salts with spectator ions are used. Examples of such alternative ions may include carbonate ions, sulfonate ions, nitrate ions, phosphate ions, thiocyanate ions, cyanate ions, chloride ions, bromide ions, iodide ions, triiodide ions, fluoride ions, bis(oxalato)borate ions (BOB), bis(malonate)borate ions (MOB), tetrakis(pentafluorophenyl)borate ions (PFPB), tetrachloroferrate ions (FeCl$_4$), and ions of tetrafluoro borate (BF$_4$), hexafluorophosphate (PF$_6$), hexafluoroantimonate (SbF$_6$), trifluoro[tri(pentafluoroethyl)]phosphate (FAP), bis(trifluoromethanesulfonyl)imide (TFSI), bis(pentafluoroethanesulfonyl)imide (TFESI) and tetrakis[(3,5-trifluoromethyl)phenyl]boric acid (TFPB), and the like.

Spectator ions when a P-type organic semiconductor is used are cations with a closed shell structure capable of forming salts with alternative ions. Examples of spectator ions may include metal ions, metal ions modified with cyclic ethers or the like, organic molecule ions, and derivatives thereof, ions of Li, Na, Cs, Mg, Ca, Cu, Ag, imidazolium, morpholinium, piperidinium, pyridinium, pyrrolidinium, ammonium, and phosphonium, and the like.

As an initiator dopant when an N-type organic semiconductor is used, a molecule or metal complex that can reduce other molecules by donating electrons is used. Specific examples of initiator dopants may include cobaltocene, decamethylcobaltocene, ruthenoselenium, ferrocene, 1,3-dimethyl-2-phenyl-2,3-dihydro-benzoimidazole, and the like. When $VL_2$ (eV) is an electron affinity originating from the LUMO level of an N-type organic semiconductor, and $VH_2$ (eV) is an ionization potential originating from the HOMO level of an initiator dopant, it is preferable to satisfy the condition: "$VL_2 \geq VH_2 - 1.0$ (eV)".

As alternative ions when an N-type organic semiconductor is used, cations with a closed shell structure capable of forming salts with spectator ions are used. Examples of such alternative ions may include metal ions, metal ions modified with cyclic ethers or the like, organic molecule ions, and derivatives thereof, ions of Li, Na, Cs, Mg, Ca, Cu, Ag, imidazolium, morpholinium, piperidinium, pyridinium, pyrrolidinium, ammonium, and phosphonium, and the like.

Spectator ions when an N-type organic semiconductor is used are anions with a closed shell structure capable of forming salts with alternative ions. Examples of such spectator ions may include carbonate ions, sulfonate ions, nitrate ions, phosphate ions, thiocyanate ions, cyanate ions, chloride ions, bromide ions, iodide ions, triiodide ions, fluoride ions, tetrafluoroborate (BF$_4$), hexafluorophosphate (PF$_6$), hexafluoroantimonate (SbF$_6$), FAP, TFSI, TFESI, BOB, MOB, PFPB, TFPB, FeCl$_4$, and the like.

To obtain a reaction of replacing initiator dopant ions forming an intermediate with alternative ions, the Gibbs energy of the system should be stabilized by the pair formation between the initiator dopant ions and the spectator ions or by the pair formation between the organic semiconductor and the alternative ions.

Fig. 5 illustrates an example when the dopant layer 22 is formed on the organic semiconductor film 21 of a P-type organic semiconductor. In this example, the treatment liquid 37 is prepared by dissolving, in a solvent, $F_4$TCNQ, which forms an initiator dopant, CsTFSI (cesium (I) bis(trifluoromethanesulfonyl)imide, CAS No.: 91742-16-4), which forms spectator ions and alternative ions, and PMMA as a retaining material, where the spectator ion is [Cs]⁻, and the alternative ion is [TFSI]⁺. The method for spreading the treatment liquid 37 over the organic semiconductor film 21 is not limited, and, for example, various methods such as coating or spin coating may be used.

As the solvent for the treatment liquid 37, TFE (2,2,2-trifluoroethanol) is used. It is confirmed that the use of TFE is effective in increasing the doping amount in the organic semiconductor film 21, improving yield, improving the stability of the doped state of the organic semiconductor film 21 against heat, improving stability over time, and reducing the activation energy in the electrical conduction of the doped layer 28, i.e., reducing the resistance temperature coefficient. An increase in the doping amount increases the carrier density in the doped layer 28, resulting in higher conductivity, and the resistance of the organic semiconductor film 21 (doped layer 28) becomes lower, resulting in lower noise at the output of the strain gauge 10. As such, the lower noise and reduced resistance temperature coefficient allow the strain gauge 10 to detect strain with high accuracy. It is confirmed that when TFE is used, the decrease in activation energy is significant, and the activation energy of the doped layer 28 can be at most 6 meV, i.e., 6 meV or less. A doped layer 28 with an activation energy of 6 meV or less is preferable as those for the strain gauge 10.

As solvents for the treatment liquid 37, organic solvents such as acetonitrile or butyl acetate may be used in addition to TFE.

After the formation of the dopant layer 22, the first protective layer 23a and the second protective layer 23b are sequentially formed. The first protective layer 23a is formed by a method such as coating or spin coating. The second protective layer 23b is formed by a method such as coating or chemical vapor deposition (CVD).

After the formation of the second protective layer 23b, the film 24 is formed. The film 24 is formed by depositing Al at an area directly above the organic semiconductor film 21, for example, using a mask, on the surface of the second protective layer 23b directly above the organic semiconductor film 21. A method for forming the film 24 is not limited thereto and can be formed using a method according to the material of the film 24.

When the strain is measured using the strain gauge 10, the front surface of the measurement target 15 is affixed in close contact with the back surface of the substrate 11, as described above. Then, a detection circuit is connected to the terminals 13a and 14a. Along with the deformation of the front surface of the measurement target 15, the substrate 11 deforms, and the organic semiconductor film 21 that includes the doped layer 28 is stretched or compressed. Then, the carrier mobility of the doped layer 28 changes in response to the stretching or compression, and the resulting change in the electrical resistance of the organic semiconductor film 21 is electrically detected by a detection circuit via the terminals 13a and 14a. That is, a detection signal according to the electrical resistance of the element part 12 can be obtained from the detection circuit. This allows the strain of the measurement target 15 to be measured.

Fig. 6 illustrates an example in which a dummy strain gauge 40 for temperature compensation is arranged together with the strain gauge 10. The dummy strain gauge 40 has a configuration in which the element part 12 is formed on the substrate 11. Since the dummy strain gauge 40 has the same configuration as the strain gauge 10, the same reference sign as the strain gauge 10 is assigned to the dummy strain gauge 40, and the explanation of the detail thereof is omitted. This dummy strain gauge 40 is affixed to the measurement target 15 so that the measurement axis direction thereof should be perpendicular to the strain direction of the measurement target 15. Accordingly, the measurement axis directions of the strain gauge 10 and the dummy strain gauge 40 are perpendicular to each other.

The organic semiconductor film 21 has good sensitivity with respect to the strain in the direction in which the main chain plane of the organic semiconductor faces, but shows low sensitivity with respect to the direction perpendicular to the above direction. Therefore, the use of the electrical resistance of the dummy strain gauge 40 allows the effect of temperature to be canceled and the strain of the measurement target 15 to be measured with the strain gauge 10.

When the temperature is compensated, the dummy strain gauge 40 may be mounted in a part of the measurement target 15 where the strain does not occur or a part different from the measurement target 15 controlled to be the same temperature. In any case, when the dummy strain gauge 40 is mounted at a position where the strain does not occur, the measurement axis direction thereof may be any direction.

The organic semiconductor film 21 (doped layer 28) has a larger resistance value than a metal foil used for common strain gauges. This is advantageous in detecting minute strains while reducing the effect of temperature and the like. For example, the resistance value of the strain gauge 10 using the organic semiconductor film 21 (doped layer 28) was 17.4 kΩ for one actually fabricated, which was about 4 orders of magnitude larger than the resistance value of a wire with a resistance of 1 Ω or less. Thus, even if the resistance value of the wire changes by, for example, about 1% (10000 ppm) due to temperature change or the like, the effect on the overall resistance value is about 1 ppm. In consideration that the gauge coefficient is about 20 or more, this only affects strain detection by about 0.05 ppm. Meanwhile, in a strain gauge using a metal foil with a resistance value of about 100 Ω and a gauge coefficient of about 2, when the resistance value of a wire changes by 1% due to temperature or the like, the overall resistance value changes by about 100 ppm. This affects the detection of the strain amount of about 50 ppm.

As such, the strain gauge 10 using the organic semiconductor film 21 constituted by an organic semiconductor single crystal with a relatively high resistance value and a high gauge coefficient, as described above, is advantageous in detecting minute strains, and by making the resistance temperature coefficient small, a small resistance temperature coefficient can be achieved for the strain gauge 10 as a whole, including the wires.

When a strain is measured with the strain gauge 10, it is preferable to apply an AC voltage to the element part 12 (organic semiconductor film 21). This is because if a DC voltage is applied to the organic semiconductor film 21, the drift of properties of the element part 12 is large because the bias of distribution of ions or the like in the doped layer 28 occurs in the channel direction, but if an AC voltage is applied, no drift of properties due to such bias occurs. For this reason, it is preferable to apply an AC voltage to the strain gauge 10 when measuring either static strain or dynamic strain.

The connection and arrangement of the strain gauge and the dummy strain gauge in a detection circuit with a strain gauge or a dummy strain gauge in addition to the strain gauge can be a well-known one. For example, one-gauge methods such as double wire system or triple wire system, two-gauge methods such as an active dummy method or a perpendicular arrangement method, or four-gauge methods may be used.

Fig. 7 illustrates a measurement device 50 using the strain gauge 10. This measurement device 50 includes a Wheatstone bridge 51 and a lock-in amplifier 52, which constitute the detection circuit, and a power source 54. The power source 54 outputs an AC voltage with a frequency f. For example, the frequency f is set to be within the range of about 100 Hz to about 1000 Hz.

The Wheatstone bridge 51 includes the strain gauge 10 as one resistor and the other three resistors 51a to 51c connected to the strain gauge 10. To the Wheatstone bridge 51, an AC voltage from the power source 54 is applied.

The Wheatstone bridge 51 is adjusted so that, for example, the Wheatstone bridge 51 should be in an equilibrium state, i.e., the output voltage $V_0$ to the lock-in amplifier 52 should be 0 V by adjusting the resistance value of the resistor 51a. If the dummy strain gauge 40 for temperature compensation is mounted, as in the example illustrated in Fig. 6, the dummy strain gauge 40 should be connected as the resistor 51c.

The lock-in amplifier 52 has an instrumentation amplifier (OP amplifier) 52a, a mixer 52b, and a low pass filter 52c. The instrumentation amplifier 52a differentially amplifies the output voltage $V_0$ from the Wheatstone bridge 51. The mixer 52b receives the input of an output voltage from the instrumentation amplifier 52a as an input signal and also receives the input of an AC voltage from the power source 54 as a reference signal and outputs an output signal obtained by multiplying these signals. The low pass filter 52c transmits low-frequency components of the output signal from the mixer 52b while cutting high-frequency components, and simultaneously averaging the low-frequency components to convert the output signal to DC. This allows a detection signal $V_1$ obtained by extracting minute signals based on the electrical resistance of the strain gauge 10 according to the strain from the output voltage $V_0$ to be obtained. The detailed configuration of the lock-in amplifier 52 can be the same as that of a conventional lock-in amplifier.

The element part 12 has higher resistance than a strain gauge including a metal resistor (metal foil) and an inorganic semiconductor and is more susceptible to the effect of thermal electromotive force or the like generated steadily by the Seebeck effect caused by minute temperature differences that occur in the element. However, the measurement using the lock-in amplifier 52, as mentioned above, removes noise components by the thermal electromotive force thereof or the like and can only detect original signal components of strains in response to AC voltage. Accordingly, it is very useful to use the lock-in amplifier 52 in the strain gauge 10 with the element part 12.

Examples

A plurality of samples A1 to A6 of the strain gauge 10 were fabricated, and the properties of the samples were tested. The base layer 17 of the substrate 11 of the samples A1 to A6 was formed of polyimide to have a thickness of 16 um, and the insulating layer 18 was formed of p-xylene to have a thickness of 100 nm. The organic semiconductor film 21 was formed by an edge-casting method, and electrodes 26 and 27 were formed of Au. Table 1 shows the organic semiconductor, channel length L, and channel width W of the organic semiconductor film 21 in the samples A1 to A6.

Regarding the samples A1 to A6, a treatment liquid 37 was prepared following the formulation listed in Table 1 using $F_4TCNQ$ as an initiator dopant and [TFSI]- as an alternative ion. [Cs]$^+$ is used as a spectator ion for the samples A1 to A6. This treatment liquid 37 was spread over the substrate 11 with the organic semiconductor film 21 to form the dopant layer 22. The treatment liquid 37 was spread by spin coating and, after that, baked at 80°C to evaporate the solvent. For the protective layer 23, the first protective layer 23a was formed of CYTOP to a thickness of 200 nm, and the second protective layer 23b was formed of p-xylene to a thickness of 200 nm. The film 24 was formed of Al to a thickness of 50 nm.

[Table 1]

| Sample | Doped film preparation liquid | | | | Organic semiconductor | Channel length L ($\mu$ m) | Channel width w ($\mu$ m) |
|---|---|---|---|---|---|---|---|
| | Solvent | Retaining material | $F_4TCNQ$ | CsTFSI | | | |
| A1 | TFE | PMMA (2wt%) | 10mM | 10mM | C8-DNBDT-NW | 400 | 4000 |
| A2 | ACN | PMMA (5wt%) | 0.3wt% | 3wt% | C8-DNBDT-NW | 200 | 200 |

(continued)

| Sample | Doped film preparation liquid | | | | Organic semiconductor | Channel length L | Channel width w |
| | Solvent | Retaining material | F$_4$TCNQ | CsTFSI | | ($\mu$ m) | ($\mu$ m) |
|---|---|---|---|---|---|---|---|
| A3 | TFE | PMMA (2wt%) | 10mM | 10mM | C8-DNBDT-NW | 800 | 4000 |
| A4 | ACN | PMMA (5wt%) | 10mM | 100mM | C8-DNBDT-NW | 200 | 200 |
| A5 | ACN | PVDF-HFP (5wt%) | 0.3wt% | 0.3wt% | C8-DNBDT-NW | 400 | 200 |
| A6 | ACN | PVDF-HFP (5wt%) | 0.3wt% | 0.3wt% | C8-DNBDT-NW | 200 | 200 |
| *M=mol/dm$^3$ | | | | | | | |

(I-V Properties and Electric Conductivity)

The I-V property was measured on the sample A1. Fig. 8 shows this measurement result. Fig. 9 shows the electrical conductivity of the organic semiconductor film 21 (doped layer 28) for eight pieces of the sample A1. Since the current flowing through the organic semiconductor film 21 is the doped layer 28 on the surface thereof, the unit of the electric conductivity is "$\mu$S". The measurement results found that the sample A1 had linear I-V properties. Furthermore, it was found that the electrical conductivity of the organic semiconductor film 21 of the sample A1 was about 4 $\mu$S/sq. to about 5 $\mu$S/sq. The electric conductivity of the organic semiconductor film 21 measured on the sample A2, which used acetonitrile as the solvent for the treatment liquid 37, was about 2 $\mu$S/sq. This result found that the use of TFE as a solvent for the treatment liquid 37 was preferable to increase the doping amount with respect to the organic semiconductor film 21.

The treatment liquid 37 used for the sample A2 changed color from yellow to green immediately after the preparation, which showed the progress of deactivation of F$_4$TCNQ. Meanwhile, the treatment liquid 37 used for the sample A1 retained the yellow color originally exhibited by F$_4$TCNQ even after two days at 50°C after the preparation. This found that the use of TFE as a solvent for the treatment liquid 37 was preferable to stably maintain the doping amount of the organic semiconductor film 21 and increase the stability over time of the properties of the strain gauge 10. Furthermore, it was confirmed that the treatment liquid 37 containing TFE as a solvent showed good wettability against the organic semiconductor film 21, which was desirable for fabricating the element part 12.

(AC Voltage)

The drifts (rate of voltage fluctuation) when an AC voltage was applied and when a DC voltage was applied were measured respectively using the sample A1. For the measurement, a metal plate with the sample A1 affixed thereto was periodically and repeatedly bent at a constant magnitude under constant temperature conditions. The resistance value of the sample A1 was 17.4 kQ. The drift at an AC voltage was measured by applying an AC voltage (2 V) from an AC power source 56 to a voltage-dividing circuit including a strain gauge 10 (sample A1) and a fixed resistor 55 that are connected in series, and the change in the voltage drop of the strain gauge 10 (sample A1) was measured, as illustrated in Fig. 10. The drift at a DC voltage was measured by applying an DC voltage (2 V) using a DC power source, instead of the AC power source 56. The resistance of the fixed resistor was 17.4 k$\Omega$.

Figs. 11 and 12 show the results of the above measurement. Fig. 11 illustrates a drift when an AC voltage was applied, and Fig. 12 illustrates a drift when a DC voltage was applied. These measurement results found that drift when an AC voltage was applied was better suppressed compared to that when a DC voltage was applied. That is, it was confirmed that when the DC voltage was applied, ion bias occurred in the doped layer 28, whereas when an AC voltage was applied, such bias did not occur. Accordingly, it was found that a constitution applying an AC voltage to the element part 12 was preferable. Furthermore, since drift was suppressed to a certain degree also when a DC voltage was applied, and when an AC voltage was applied, drift was suppressed for a long period of time, the effect of the film 24 was found to be effective. Furthermore, Fig. 13 shows a result of drift measurement for a longer time when an AC voltage was applied. This result found that drift was also suppressive even over a long period of time.

(Resistance Temperature Coefficient)

The resistance temperature coefficient was measured and the activation energy was determined on the samples A3 and A4. Fig. 14 shows the relationship between the temperature at this measurement and the surface resistivity of the organic semiconductor film 21 (doped layer 28). The obtained resistance temperature coefficient was 600 ppm/°C for the sample A3 and 2600 ppm/°C for the sample A4. Meanwhile, the activation energy was at most 6 meV for the sample A3 but about 20 meV for the sample A4, which was much larger than that of the sample A3. This result found that the use of TFE as a solvent for the treatment liquid 37 was preferable to achieve a high doping amount and small resistance temperature coefficient of the strain gauge 10. The low activation energy of the sample A3 is believed to be attributed to the fact that the effect of trap state density or the like is reduced by increasing the doping amount sufficiently in an organic semiconductor single crystal with band conductivity.

(Temperature Compensation)

Two sheets of sample A3 (hereinafter, one is referred to as a sample A3a, and the other is referred to as a sample A3b) were applied to a similar voltage-dividing circuit to that in Fig. 10, and the effect of temperature compensation by the dummy strain gauge 40 was tested. At this time, the sample A3a was used as the strain gauge 10, the sample A3b was used as a fixed resistor, a DC voltage (1 V) was applied from a DC power source to the voltage-dividing circuit, and the change in the voltage drop of the sample A3a against the temperature change was measured. Fig. 15 shows this measurement result. In the graph of Fig. 15, the abscissa axis is temperature, and the ordinate axis is a ratio of the change ($\Delta$V) in the voltage drop against the average voltage drop (V) in the measurement range. This measurement found that the resistance temperature coefficient was 55 ppm. This found that the resistance temperature coefficient could be 1/0 or less compared to the case of a single strain gauge 10.

(Minute Strain Measurement)

Using a one-axis automatic stage 61 illustrated in Fig. 16, the degree of bending of a stainless-steel plate 62 (thickness: 50 um) with the sample A1 affixed thereto as the strain gauge 10 was changed repeatedly, and the change in the voltage drop of the sample A1 at this time was measured. Both ends of the stainless-steel plate 62 were respectively fixed to the fixed table 61a and the movable table 61b of the one-axis automatic stage 61, and the movable table 61b was reciprocated in one direction to change the degree of bending of the stainless-steel plate 62 repeatedly and periodically. The sample A1 was affixed to the center of the stainless-steel plate 62 together with the reference strain gauge 64. The reference strain gauge 64 is a commercially available one with a metal thin film. In Fig. 16, the bending state of the stainless-steel plate 62 is depicted exaggeratedly.

The one-axis automatic stage 61 has a movable table 61b moved by receiving an input of driving pulse from the exterior. In the measurement, the movable table 61b was controlled such that the movable table 61b was gradually moved from the original position by receiving an input of driving pulses, and the moving direction of the movable table 61b was reversed for every reception of an input of 10000 driving pulses. The input of 10000 driving pulses was equivalent to a movement of 200 um of the movable table 61b and a strain of about 17 ppm of the stainless-steel plate 62.

The voltage drop of the sample A1 was measured using those similar to the voltage-dividing circuit illustrated in Fig. 10, except that a fixed resistor 55 of 20 kQ was used and an AC voltage (2 V) was applied from an AC power source to a voltage-dividing circuit. Similarly, the voltage drop was also measured on the reference strain gauge 64. In the measurement on the reference strain gauge 64, a fixed resistor 55 of 120 $\Omega$ was used, and a DC voltage (2 V) was applied from a DC power source to a voltage-dividing circuit.

Fig. 17 shows the change in the voltage drop of the sample A1 measured as above, and Fig. 18 shows the change in the voltage drop of the reference strain gauge 64. This result found that the voltage drop of the sample A1 changed periodically, as with the voltage drop of the reference strain gauge 64, and a strain of 17 ppm could be detected.

The sample A1 on the stainless-steel plate 62 was connected as the strain gauge 10 illustrated in Fig. 7, and the strain using the lock-in amplifier 52 was measured. The AC voltage of the power source 54 was set to 2 V, and the frequency f was set to 123.45 Hz. The Wheatstone bridge 51 was adjusted so that the Wheatstone bridge 51 should be in an equilibrium state, i.e., the output voltage $V_o$ to the lock-in amplifier 52 should be 0 V while using a resistor 51a of 20 kQ.

Fig. 19 shows the detection signal $V_1$ of the measurement device 50 when a cycle of operations of inputting 10000 driving pulses to the one-axis automatic stage 61 to move the movable table 61b from the original position, and after that, returning the movable table 61b to the original position with 10000 driving pulses was repeated several times. This result found that the S/N of the detection signal $V_1$ was about 10, which showed 2 ppm strain resolution.

Then, the movable table 61b of the one-axis automatic stage 61 was moved in turn from the original position to a first position with 2000 driving pulses input, and then to a second position with 4000 driving pulses input, with the origin position as a reference, and after that, the movable table 61b was moved in the reversed direction to the original position via the first position. Fig. 20 shows the detection signal $V_1$ of the measurement device 50 at this time. In Fig. 20, reference signs S0, S1, and S2 are assigned to parts corresponding to the original position, the first position, and the second position, respectively. This result found that level changes of the detection signal $V_1$ in response to the movement from the original position to a first position and from the first position to a second position were obtained, and a strain of 3.4 ppm, which was equivalent to the driving pulse for 2000 pulses, could be detected.

(Hygroscopicity)

The I-V properties were measured on samples A5 and A6, which used PVDF-HFP with low hygroscopicity as a retaining material. Fig. 21 shows this measurement result. The electric conductivity of the organic semiconductor film 21 (doped layer 28) of these samples A5 and A6 were both 6 $\mu$S. The electric conductivity of the element part 12 with a similar composition that did not contain a retaining material in the dopant layer 22 could be made to be about 4 $\mu$S.

[Reference Signs List]

10    Strain gauge
11    Substrate
12    Element part
21    Organic semiconductor film
22    Dopant layer
23    Protective layer
24    Film
28    Doped layer
37    Treatment liquid
50    Measurement device

**Claims**

1. An organic semiconductor element comprising:

   an organic semiconductor film that is formed as a single crystal of an organic semiconductor and has a doped layer on a surface thereof;
   a dopant layer that is formed on a surface of the organic semiconductor film and contains an ion pair-forming ion to form an ion pair with an ion of the organic semiconductor produced by generating carriers in the doped layer; and
   a film that is formed to cover the dopant layer on the surface of the organic semiconductor film and has one or both of a light-shielding property that suppresses incidence of light into the organic semiconductor film and into the dopant layer, and a moisture-proof property that suppresses permeation of water into the dopant layer.

2. The organic semiconductor element according to claim 1, wherein the film is formed of aluminum.

3. The organic semiconductor element according to claim 1 or 2, wherein activation energy in electrical conduction of the doped layer is 6 meV or less.

4. A strain gauge comprising:

   an organic semiconductor element; and
   a deformable substrate formed on one surface of the organic semiconductor element,
   the organic semiconductor element including
   an organic semiconductor film that is formed as a single crystal of an organic semiconductor and has a doped layer on a surface thereof,
   a dopant layer that is formed on a surface of the organic semiconductor film and contains an ion pair-forming ion to form an ion pair with an ion of the organic semiconductor produced by generating carriers in the doped layer,
   a film that is formed to cover the dopant layer on the surface of the organic semiconductor film and has one or both of a light-shielding property that suppresses incidence of light into the organic semiconductor film and into the dopant layer, and a moisture-proof property that suppresses permeation of water into the dopant layer, and
   a pair of electrodes electrically connected via the doped layer.

5. A measurement device comprising:

    the strain gauge according to claim 4;
    an AC power source that applies an AC voltage to the organic semiconductor element of the strain gauge; and
    a detection circuit that outputs a detection signal according to an electrical resistance of the organic semiconductor element.

6. The measurement device according to claim 5, wherein the detection circuit includes a lock-in amplifier that receives an input of a voltage according to electrical resistance of the strain gauge.

7. A method for producing an organic semiconductor element, the method comprising:

    an organic semiconductor film formation step of forming on a substrate an organic semiconductor film composed of a single crystal of an organic semiconductor; and
    a dopant layer formation step of spreading a treatment liquid over a surface of the organic semiconductor film and thereafter evaporating a solvent in the treatment liquid to form a dopant layer that supplies carriers in the surface of the organic semiconductor film,
    the treatment liquid containing 2,2,2-trifluoroethanol as the solvent, and in the treatment liquid, an ionic liquid or salt that includes an alternative ion as either a cation or an anion is dissolved in the solvent, and an initiator dopant that oxidizes or reduces the organic semiconductor to form, after the oxidation or reduction, an ion with an identical polarity to the alternative ion is dissolved in the solvent, where an ion of the initiator dopant forms an intermediate with the organic semiconductor, and the alternative ion is replaced with the initiator dopant of the intermediate.

8. The method for producing an organic semiconductor element according to claim 7, wherein

    the alternative ion is an ion of bis (trifluoromethanesulfonyl)imide,
    the initiator dopant is 2,3,5,6-tetrafluoro-7,7,8,8-tetracyano-quinodimethane, and
    the organic semiconductor is 3,11-dioctyldinaphtho[2,3-d:2' ,3'-d']benzo[1,2-b:4,5-b']dithiophene.

9. The method for producing an organic semiconductor element according to claim 7 or 8, wherein the treatment liquid contains a poly(methyl methacrylate) resin dissolved in the solvent.

10. The method for producing an organic semiconductor element according to claim 7 or 8, wherein the treatment liquid contains poly(vinylidene fluoride-co-hexafluoropropylene) dissolved in the solvent.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

## INTERNATIONAL SEARCH REPORT

| International application No. |
| --- |
| **PCT/JP2023/027815** |

**A. CLASSIFICATION OF SUBJECT MATTER**

***G01L 1/18***(2006.01)i
FI: G01L1/18 A

According to International Patent Classification (IPC) or to both national classification and IPC

**B. FIELDS SEARCHED**

Minimum documentation searched (classification system followed by classification symbols)

G01L 1/18-1/20; G01B 7/16; H10K 10/00-99/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2020/050288 A1 (THE UNIVERSITY OF TOKYO) 12 March 2020 (2020-03-12) paragraphs [0013]-[0042], fig. 1, 2 | 1-2, 4-6 |
| A | | 3, 7-10 |
| Y | JP 2016-1689 A (DAINIPPON PRINTING CO., LTD.) 07 January 2016 (2016-01-07) paragraphs [0071]-[0075], fig. 10 | 1-2, 4-6 |
| Y | JP 2019-534473 A (COMMISSARIAT A L'ENERGIE ATOMIQUE ET AUX ENERGIESALTERNATIVES) 28 November 2019 (2019-11-28) paragraph [0043], fig. 1D | 1-2, 4-6 |
| Y | WO 2014/050534 A1 (FUJIFILM CORP.) 03 April 2014 (2014-04-03) paragraph [0088], fig. 2 | 2 |
| Y | JP 2017-83418 A (RICOH CO., LTD.) 18 May 2017 (2017-05-18) paragraph [0133] | 5-6 |
| A | US 2020/0256748 A1 (KOREA UNIVERSITY RESEARCH AND BUSINESS FOUNDATION) 13 August 2020 (2020-08-13) | 1-10 |

☐ Further documents are listed in the continuation of Box C.     ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **15 August 2023** | **29 August 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

# EP 4 492 024 A1

**INTERNATIONAL SEARCH REPORT**
Information on patent family members

| International application No. |
|---|
| **PCT/JP2023/027815** |

| Patent document cited in search report | | | Publication date (day/month/year) | Patent family member(s) | | | Publication date (day/month/year) |
|---|---|---|---|---|---|---|---|
| WO | 2020/050288 | A1 | 12 March 2020 | JP | 2020-38133 | A | |
| | | | | US | 2021/0328164 | A1 | |
| | | | | paragraphs [0026]-[0054], fig. 1, 2 | | | |
| | | | | EP | 3848987 | A1 | |
| | | | | CN | 112997332 | A | |
| | | | | KR | 10-2021-0049889 | A | |
| | | | | TW | 202025532 | A | |
| JP | 2016-1689 | A | 07 January 2016 | (Family: none) | | | |
| JP | 2019-534473 | A | 28 November 2019 | WO | 2018/073515 | A1 | |
| | | | | US | 2019/0280048 | A1 | |
| | | | | paragraph [0050], fig. 1D | | | |
| | | | | EP | 3529834 | A1 | |
| | | | | CN | 109844947 | A | |
| | | | | KR | 10-2019-0070928 | A1 | |
| | | | | FR | 3057995 | A1 | |
| WO | 2014/050534 | A1 | 03 April 2014 | JP | 2014-81359 | A | |
| JP | 2017-83418 | A | 18 May 2017 | US | 2016/0187374 | A1 | |
| | | | | paragraph [0195] | | | |
| US | 2020/0256748 | A1 | 13 August 2020 | KR | 10-2087840 | B1 | |

Form PCT/ISA/210 (patent family annex) (January 2015)

**EP 4 492 024 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016121791 A1
- WO 2020050288 A1
- WO 2021182545 A